# EUROPEAN PATENT SPECIFICATION

(11) **EP 4 060 724 B1**
(45) Date of publication and mention of the grant of the patent: **23.08.2023**
(21) Application number: 21163698.0
(22) Date of filing: 19.03.2021
(51) Int. Cl.: H01L 23/373, H01L 23/473, H05K 7/20

(54) **A POWER MODULE COMPRISING AT LEAST ONE SEMICONDUCTOR MODULE, AND A METHOD FOR MANUFACTURING A POWER MODULE**
LEISTUNGSMODUL MIT MINDESTENS EINEM HALBLEITERMODUL UND VERFAHREN ZUR HERSTELLUNG EINES LEISTUNGSMODULS
MODULE D'ALIMENTATION COMPRENANT AU MOINS UN MODULE À SEMICONDUCTEUR, ET PROCÉDÉ DE FABRICATION D'UN MODULE DE PUISSANCE

(43) Date of publication of application: 21.09.2022
(73) Proprietor: Hitachi Energy Switzerland AG, 5400 Baden (CH)
(72) Inventor: PAVLICEK, Niko, 8041 Zurich (CH); MOHN, Fabian, 5408 Ennetbaden (CH)
(74) Representative: Epping - Hermann - Fischer

(56) References cited:
- EP-A1- 1 843 392
- EP-A1- 2 524 945
- EP-A1- 3 703 117
- WO-A1-2021/013956
- US-A1- 2010 232 112
- US-A1- 2015 108 629

## Description

The present disclosure relates to a power module comprising at least one semiconductor module, a first housing part made from a plastic material and a second housing part made from a plastic material. The present disclosure further relates to a method for manufacturing a power module.

Document US 9,613,885 B2 relates to a cooling apparatus including a plurality of discrete modules and a plastic housing. Each module includes a semiconductor die encapsulated by a mold compound, a plurality of leads electrically connected to the semiconductor die and protruding out of the mold compound, and a first cooling plate at least partly uncovered by the mold compound. The plastic housing surrounds the periphery of each module to form a multi-die module.

Document US 2011/0316143 A1 relates to a semiconductor module which includes a semiconductor unit which is made by a resin mold. The resin mold has formed therein a coolant path through which a coolant flows to cool the semiconductor chip embedded in the resin mold.

US 2010/0232112 A1 discloses a semiconductor module including: a base plate whose one surface is formed with a fin region in which a cooling fin is provided; a substrate that is disposed on the other surface of the base plate and provided with a switching device; and a case member having an internal space an opening formed in one wall of the case member so that the opening is smaller than the one surface of the base plate and larger than the fin region.

EP 1 843 392 A1 provides an electronics assembly having a housing including walls defining a fluid vessel. One or more thermally conductive heat sink devices extend through one or more openings in the housing and in thermal communication with a liquid coolant. One or more electronics devices are mounted onto a mounting surface of the heat sink devices such that the electronics devices are cooled by the liquid coolant in the fluid vessel.

DE 196 45 636 C1 discloses a power module having a power stage with a power semiconductor circuit provided on a semiconductor substrate and a cooling device, supplied with a cooling medium, having a number of heat sink elements with profiled surfaces. The underside of the semiconductor substrate is applied directly to the cooling device, with a control device having semiconductor elements mounted on a carrier supported above the power stage and connected to the latter via contact pins. A common housing encloses the power stage and the control device.

WO2021/013956 discloses a method of providing a power semiconductor module with a cooler. The power semiconductor module includes a substrate having a first substrate side for carrying at least one electric circuit and having a second substrate side being located opposite to the first substrate side. The second substrate side is connected to a first baseplate side and the baseplate also includes a second baseplate side being located opposite to its first baseplate side and being adapted for coming in contact with the cooler. The cooler includes a first casing component and a second casing component. The baseplate side is equipped with a cooling area that is surrounded by a connecting area.

There is a need for improved cooling assemblies for semiconductor modules, which are easy to manufacture and assemble, are lightweight and allow efficient cooling of power semiconductor dies.

According to a first aspect of the disclosure, a power module comprising at least one semiconductor module having a metal baseplate with an integrated cooling structure is provided. The power module further comprises a first housing part made from a plastic material and molded around at least parts of the metal baseplate to establish a form-fit connection with the at least one semiconductor module, and a second housing part made from a plastic material and joined to the first housing part to form a cavity for a coolant for cooling the integrated cooling structure of the at least one semiconductor module. In the above power module, no additional parts are necessary to attach the at least one semiconductor module to the coolant housing and guide the flow of the coolant around the integrated cooling structure. This results in a simpler manufacturing process and a lower part count. In addition, the use of plastic materials results in a particularly lightweight assembly.

According to at least one embodiment, the first housing part and/or the second housing part is made from a fiber reinforced polymer material. Fiber reinforced polymer materials combine low weight with high strength and are suitable for many application areas, including water and/or ethylene glycol-based coolants.

According to at least one embodiment, the first housing part and the second housing part are joined by at least one of a plastic welding joint, an adhesive bonding joint or a heated material fusion joint. Such joints are easy to manufacture and prevent leakage of the coolant from the cooling assembly. At the same time, manufacturing the cooling assembly from two different housing parts allows for the provision of relatively complicated housing structures.

According to at least one embodiment, the first housing part and/or the second housing part comprises at least one of polyphenylene sulfide (PPS), polycarbonate (PC) and acrylonitrile butadiene styrene (ABS), reinforced by glass fibers. The above materials are flame-resistant, can tolerate temperatures of up to 200 °C and 140 °C, respectively, and are compatible with typical coolants such as ethylene glycol.

According to at least one embodiment, the first housing part and/or the second housing part is a laminated carbon composite part. For example, the first housing part and/or the second housing part could comprise pre-impregnated composite fibers. Such materials are strong and lightweight and can be manufactured using novel processing techniques such as out-of-autoclave composite manufacturing.

According to at least one embodiment, the at least one semiconductor module comprises at least one power semiconductor die encapsulated by a mold body. This allows for the integration of conventional semiconductor modules into the disclosed power module.

According to at least one embodiment, the at least one semiconductor module comprises at least one power semiconductor die and a plurality of leads connected to the at least one power semiconductor die, wherein the plurality of leads are at least partially embedded into the plastic material of the first housing part. Embedding leads of at least one power semiconductor die into the first housing part helps to stabilize and, at the same time, insulate them from each other.

According to at least one embodiment, the power module further comprising at least one press-fit terminal, wherein the first housing part comprises a support structure configured to support the at least one press-fit terminal. Such a configuration is helpful to absorb relatively high forces during press-fitting of the module to a printed circuit board or similar carrier substrate.

According to at least one embodiment, the form-fit connection forms a seal for the coolant between the integrated cooling structure of the at least one semiconductor module and the first housing part. In this case, no additional gaskets are required to seal the cavity for the coolant, further reducing the part count of the power module.

According to a second aspect, a method for manufacturing a power module is disclosed. The method comprises the steps of:
- placing at least one semiconductor module having a metal baseplate with an integrated cooling structure in a first mold;
- molding a first housing part from a plastic material using the first mold, thereby establishing a form-fit connection between at least parts of the metal baseplate and the plastic material of the first housing part;
- molding a second housing part from a plastic material; and
- joining the first and the second housing part by a plastic joining method to form a cavity for a coolant for cooling the integrated cooling structure of the at least one semiconductor module.

The above steps enable the manufacturing of a lightweight power module using a metal insert molding process.

According to at least one embodiment, the at least one semiconductor module comprises at least one power semiconductor die, which is embedded into a mold body before the at least one semiconductor module is placed in the first mold. This enables easy integration of independently manufactured semiconductor modules into a power module. According to at least one alternative embodiment, the at least one semiconductor module comprises at least one power semiconductor die, which is directly embedded into the plastic material of the first housing part during molding of the first housing part. This approach further reduces the number of processing steps required for manufacturing of the power module.

As detailed above, the present disclosure comprises several aspects and embodiments thereof. Every feature described with respect to one of the aspects and its embodiments is also disclosed herein with respect to the other aspects, even if the respective feature is not explicitly mentioned in the context of the specific aspect.

The present invention is defined in independent device claim 1 and corresponding independent method claim 11.

The accompanying figures are included to provide a further understanding. In the figures, elements of the same structure and/or functionality may be referenced by the same reference signs. It is to be understood that the embodiments shown in the figures are illustrative representations and are not necessarily drawn to scale.
Figure 1 shows schematically a first cross-section through a conventional power module.
Figure 2 shows schematically a second cross-section through the power module of Figure 1.
Figure 3 shows schematically a first cross-section through a power module according to an embodiment of the present disclosure.
Figure 4 shows schematically a second cross-section through the power module of Figure 3.
Figure 5 shows schematically a cross-section through a power module according to another embodiment of the present disclosure.
Figure 6 shows schematically a cross-section through a power module according to another embodiment of the present disclosure.
Figure 7 shows schematically a method for manufacturing a power module.

While the invention is amenable to various modifications and alternative forms, specifics thereof have been shown by way of example in the figures and will be described in detail. It should be understood, however, that the intention is not to limit the invention to the particular embodiments described. On the contrary, the intention is to cover all modifications, equivalents, and alternatives falling within the scope of the invention defined by the appended claims.

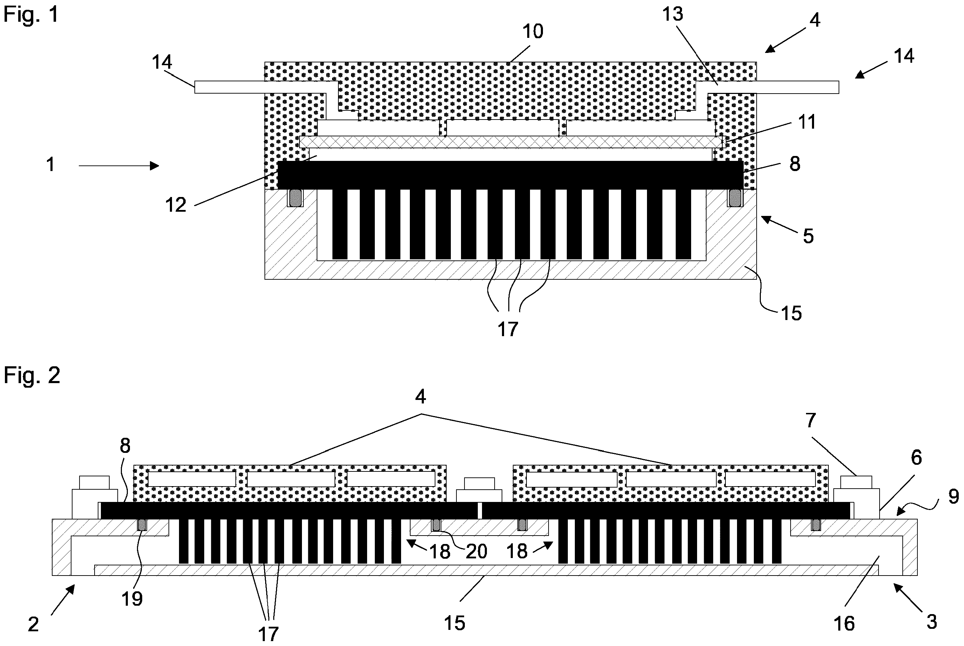

To aid understanding of the present disclosure, at first a conventional power module 1 having an aluminum alloy cooler assembly is described with reference to Figures 1 and 2.

Figure 1 shows, in a schematic manner, a first cross-section of the power module 1, wherein the coolant flows into or out of the plane shown in Figure 1. Figure 2 shows a second, perpendicular cross-section through the same power module 1, wherein the coolant flows from a first port 2 shown on the left-hand side to the second port 3 shown on the right-hand side of Figure 2.

The power module 1 comprises two semiconductor modules 4 attached to a cooling assembly 5. As can be seen in Figure 2, the semiconductor modules 4 are attached to the cooling assembly 5 by means of clamps 6 and corresponding screws 7 clamping a baseplate 8 of each semiconductor module 4 to a top surface 9 of the cooling assembly 5.

The baseplate 8 is made from a metal material and embedded into a mold body 10. The mold body 10 also embeds a substrate 11, on which the actual semiconductor dies 12 forming the power component of the power module 1 are formed. Several conductive leads 13 are attached to the backside of the substrate 11. The leads 13 extend to terminals 14 outside the mold body 10.

The cooling assembly 5 is made from a hollow aluminum alloy body part 15 which is used to guide a coolant 16, such as an ethylene glycol-water mixture from the first port 2 to the second port 3 or vice versa. On its way from the first port 2 to the second port 3, the liquid coolant 16 passes through an array of pin fins 17. The pin fins 17 extend from the baseplate 8 and protrude through corresponding openings 18 in the aluminum alloy body part 15 into the flow of the coolant 16, and therefore significantly increase a surface area of the baseplates 8 exposed to the coolant 16. In operation, heat dissipated by the semiconductor dies 12 is conducted via the baseplates 8 and the arrays of pin fins 17 to the coolant 16, thus significantly improving a thermal flow away from the semiconductor dies 12 as compared to semiconductor power modules without integrated cooling structure.

In an automotive application, the first and second ports 2 and 3 of the cooling assembly 5 can be connected to a general cooling system of a vehicle. To maintain a liquid-tight seal between the semiconductor modules 4 and the cooling assembly 5, O-Ring gaskets 19 are placed in respective grooves 20 surrounding the openings 18 of the cooling assembly 5.

The above power module 1 and cooling assembly 5 work reliably in different application scenarios. However, forming of the cooling assembly 5 from a metal material, such as an aluminum alloy, adds weight to the overall power module 1. Moreover, the assembly of such a multi-part, partly metal power module 1 results in relatively high production costs and a high part count. Thus, there is a need to further decrease the weight and component count of such power modules.

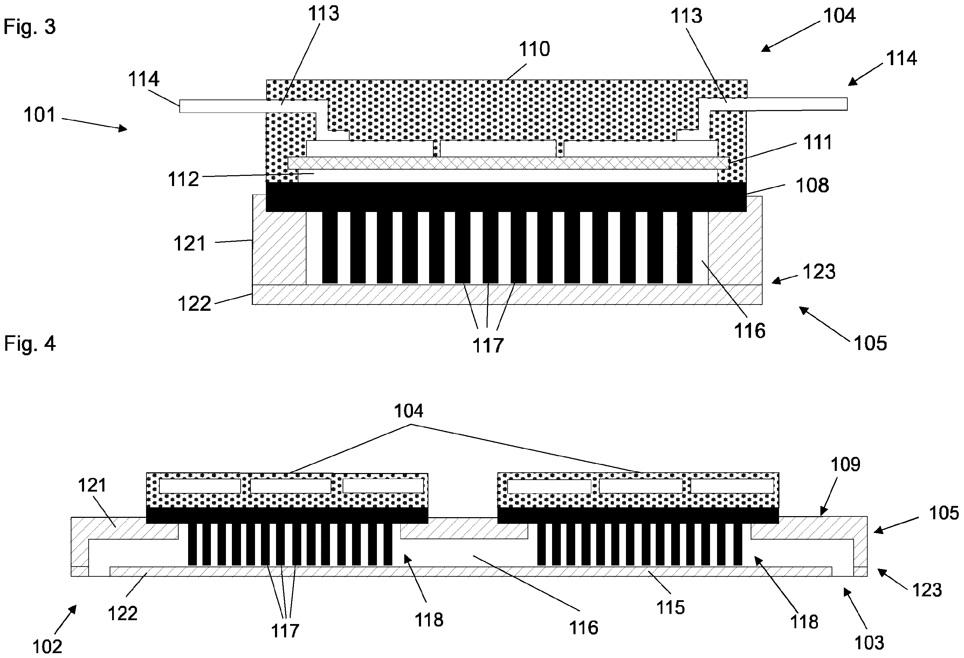

Figures 3 and 4 show, in a schematic manner, cross-sections through a power module 101 according to a first embodiment of the present disclosure. The cross-section shown in Figures 3 and 4 correspond to the cross-section of the power module 1 shown in Figures 1 and 2, respectively. For ease of explanation, corresponding reference signs are used to explain the embodiment shown in Figures 3 and 4.

The power module 101 according to the described disclosure comprises two semiconductor modules 104 and a common cooling assembly 105. Of course, power modules comprising further semiconductor modules 104 or only a single semiconductor modules 104 are also possible. The power module 101 may be part of a liquid cooled inverter, for example. As detailed before, each semiconductor module 104 comprises a mold body 110, into which a substrate 111 carrying one or several semiconductor dies 112 is embedded. For example, the semiconductor dies 112 may be IGBTs, diodes, or MOSFETs of a power switching stage of an inverter. The semiconductor dies 112 and/or the substrate 111 can be contacted from terminals 114 by means of leads 113. The mold body 110 also partly encloses a metal baseplate 108 in thermal connection with the semiconductor dies 112. The metal baseplate 108 has an integrated cooling structure in the form of several pin fins 117 extending from the baseplate 108 on the opposite side of the semiconductor dies 112.

Contrary to the cooling assembly 5 shown in Figures 1 and 2, the cooling assembly 105 shown in Figures 3 and 4 is made from a plastic material. For example, a polymer material, such as glass-fiber reinforced polymer, or carbon-fiber reinforced polymer, may be used. To form the cooling assembly 105, two separate housing parts, a first housing part 121 and a second housing part 122 are joined by a watertight joint 123. In the described embodiment, the first housing part 121 and the second housing part 122 are formed by molding and contain a cavity through which a coolant 116 can flow from a first port 102 to a second port 103 or vice versa. Together, the first housing part 121 and the second housing part 122 form a plastic body part 115.

Contrary to the assembly shown in Figures 1 and 2, the two semiconductor modules 104 and the common cooling assembly 105 are fully integrated by partially embedding the two semiconductor modules 104 into the plastic material of the first housing part 121. This is achieved by metal insert molding, which integrates the metal baseplate 108 firmly into the first housing part 121 of the cooling assembly 105.

For example, the semiconductor modules 104 comprising the metal baseplate 108 are placed in a form used for molding the first housing part 121. Then, a plastic material is injected into the form to mold the first housing part 121 with parts of the baseplate 108 being embedded in the plastic material. Consequently, no further parts or steps for securing the semiconductor modules 104 to the cooling assembly 105 are required. The form used for molding is shaped such that the pin fins 117 protrude through corresponding openings 118 of the first housing part 121. As can be seen in Figures 3 and 4, the pin fins 117 protrude into the cavity for the coolant 116.

Glass-fiber reinforced polymers can be manufactured by standard injection molding processes. The fibers are typically short and not oriented in a particular direction. Many different materials are commercially available, for example Solvay Ryton or Covestro Bayblend. Such a cooling assembly 105 and corresponding power module 101 have several advantageous properties. For example, the use of reinforced polymer material results in a relatively low weight and cost of the cooling assembly 105. At the same time, many thermoplastic polymer materials, for example Solvay Ryton comprising PPS or Covestro Bayblend comprising a blend of PC and ABS, pass UL94 V-0 flammability requirements and are heat-resistant up to 200 °C and 140 °C, respectively, as required, for example, in the field of automotive power modules. Moreover, Ryton is also specifically stated to be compatible with ethylene glycol, an anti-freeze component used in cooling systems of various water-based coolers. Moreover, polymer injection molding techniques are more flexible than conventional metal machining or die-casting techniques, thus allowing for the production of more complicated details of the plastic body part 115.

Alternatively, instead of using injection molded plastic parts, it is also possible to form the first housing part 121 and/or second housing part 122 from pre-impregnated composite fibers, for example carbon fibers. Carbon-fiber reinforced polymers are typically more expensive to manufacture and known from aerospace, or sports equipment, where high strength-to-weight ratios are essential. Their fibers are long, woven, and/or oriented in a particular direction. The fibers are made from synthetic polymers, as for example polyacrylonitrile or rayon. For certain applications, sheets with epoxy pre-impregnated into the fibers, also referred to as "pre-pregs" Such high-performance parts can be manufactured in autoclaves with heated pressure chambers. More recently, molding without use of an autoclave can be used to manufacture parts from layered sheets of carbon fiber, referred to "out-off-autoclave" manufacturing. Out-of-autoclave composite manufacturing based on resin transfer molding or balanced pressure fluid molding enables their mass production at relatively low cost.

The watertight joint 123 between the two housing parts 121 and 122 can be formed, for example, using ultrasonic or laser-based plastic welding, an appropriate adhesive bond or a heated material fusion joint and alleviates the need for a separate seal between the two housing parts.

As before, the array of pin fins 117 formed on the lower surface of the baseplate 108 protrude through an opening 118 of the cooling assembly 105. In the described embodiment, two openings 118 corresponding to the two semiconductor power modules 104 are formed in the first housing part 121.

Unlike in the embodiment shown in Figures 1 and 2, the attachment and sealing of the semiconductor modules 104 to a top surface 109 of the cooling assembly 105 is achieved directly during molding of the first housing part 121. Accordingly, no separate attachment or sealing parts, such as screws and clamps, or an O-ring or other form of gasket is required for the embodiment shown in Figures 3 and 4. In the described embodiment, the surface energy on the areas to be bonded may be greater than 45 mN/m and their surface roughness, Ra, may be between 4 um and 6 µm.

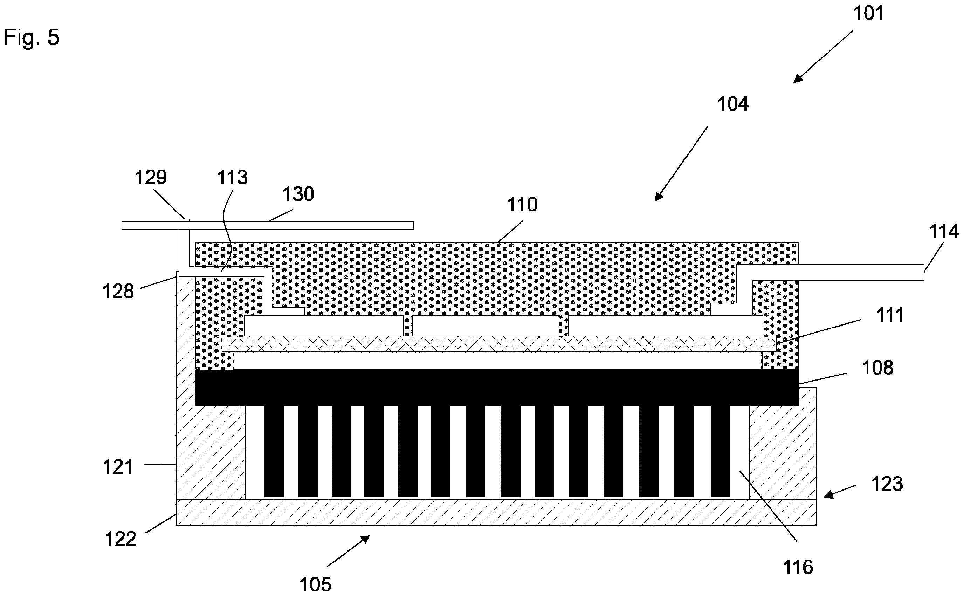

Figure 5 shows, in a schematic manner, a cross-section through a power module 101 according to a second embodiment of the disclosure. Again, corresponding reference signs will be used with regard to the second embodiment shown in Figure 5. Accordingly, the description of corresponding parts will not be repeated here for the sake of conciseness.

In the embodiment shown in Figure 5, the plastic material of the first housing part 121 extends, in a vertical direction, beyond the plane of the metal baseplate 108. In particular, it also encompasses the left-hand side of the mold body 110, forming a support structure 128 that partly embeds and supports one or more press-fit terminal 129 arranged on the left-hand side. This results in at least two further advantages.

Firstly, the spacing of the individual leads 113 and press-fit-terminals 114 can be closely controlled, thus avoiding any unwanted electrical connections between neighboring electrical connections. This effect can be further improved if parts of the lead 113 leading to the terminals 114 are fully embedded into the plastic material, resulting in a higher resistance and thus lower creep current between individual leads 113. Thus, this embodiment enables closely spaced terminals 114 or 129 for improved electrical performance without violating the required creepage distances.

Secondly, the first housing part 121 can also act as a mechanical support. This is particularly useful to mechanically support the press-fit terminals 129 during insertion into corresponding openings of a printed circuit board 130, as shown in Figure 5.

Attention is drawn to the fact that the embodiment shown in Figure 5 uses different types of terminals on opposite ends of the power modules 104. In particular, the press-fit terminals 129 are used on the left-hand side, whereas the terminals 114 on the right-hand side are configured as flat metal terminals. Of course, it is also possible to configure all terminals 114 as press-fit terminals.

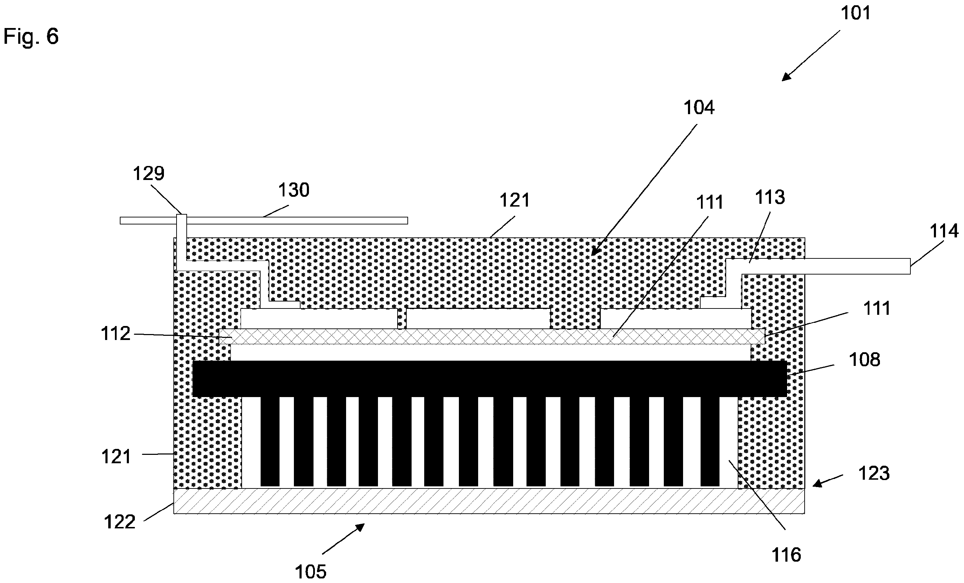

In a further embodiment shown in Figure 6, the first housing part 121 essentially embeds all components of the semiconductor module 104. That is to say, the metal baseplate 108, the semiconductor substrate 111, the semiconductor dies 112 and the leads 113 are directly embedded into the plastic material of the first housing part 121. Accordingly, no separate molding step for preparing a mold body surrounding the semiconductor dies 112 is necessary.

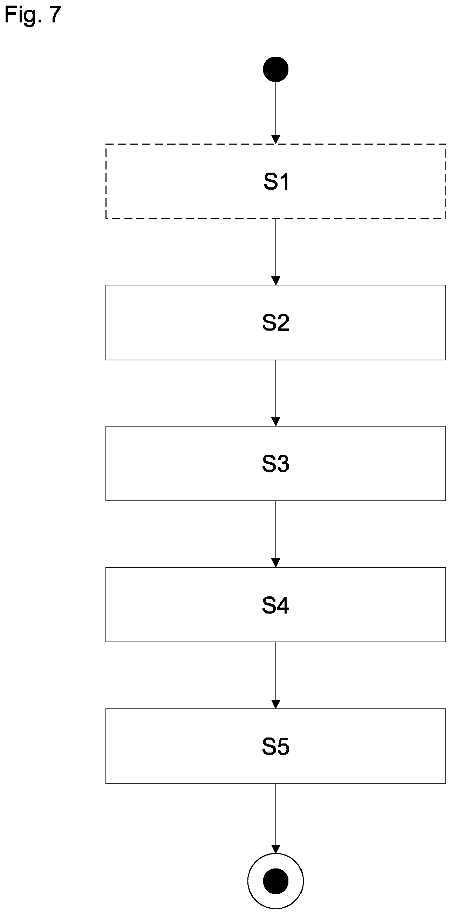

Figure 7 shows, in a schematic way, a method for manufacturing a power module 101 using steps S1 to S5. Attention is drawn to the fact that steps S1 to S5 may be performed in a different order and/or in parallel. For example, the second housing part 122 may be formed before the first housing part 121.

In optional step S1, a semiconductor module 104 is formed. In particular, a substrate 111 carrying one or more semiconductors 112 may be attached to a baseplate 108. Individual parts of the substrate 111 or the semiconductor die 112 may be connected to electrical leads 113. These components may then be encapsulated by a separate mold body 110 for electrical isolation and mechanical stability of the semiconductor module 104. However, as detailed above, the individual parts of the semiconductor module 104 may also be directly embedded into a plastic material during step S3.

In step S2, at least one semiconductor module 104 with a metal baseplate is placed in a first mold. Specifically, one or more of the semiconductor modules 104 prepared in step S1 can be placed in a mold used for metal insert molding. This also facilitates precise relative alignment between terminals 114 of multiple semiconductor modules 114 placed in the same mold form. Thus, tight positioning tolerances between the different semiconductor modules 114, required for example for the electrical connection of module terminals 114 are facilitated, as conventional mold tools are very precise. Moreover, the semiconductor modules 104 will be aligned in the form so as to make sure that the integrated cooling structure attached to the metal baseplate 108 protrudes to the outside of a volume to be filled with a plastic material during molding in step S3.

In step S3, a first housing part 121 is formed using molding from a plastic material using the first mold. By injecting the plastic material into the first mold, a mechanically stable form-fit connection between at least parts of the metal baseplate 108 and the plastic material of the first housing part 121 is formed. In consequence, the semiconductor modules 114 are strongly attached to the first plastic housing part 121, forming a leak-tight seal. It should be noted that the mold temperature during the injection and similar molding processes is typically well below operation temperature of the power semiconductor module 104. Therefore, there is low risk for degradation of bond layers or mold compound adhesion within the power semiconductor module 104.

In step S4, a second housing part is formed using molding. The materials and techniques employed in step S4 are similar to the materials and techniques used in step S3.

In step S5, the first and second housing parts 121 and 122 are joined by a suitable plastic joining method to form a liquid-tight cavity for a coolant 116. The first housing part 121 and the second housing part 122 are configured and aligned so that the integrated cooling structure of the baseplate 108 protrudes into the cavity for the coolant 116. As detailed above, laser or ultrasonic welding may be employed to form a watertight weld seam between the two housing parts 121 and 122. Alternatively, an adhesive bonding joint or a heated material fusion joint may be formed using an adhesive or by partially melting the material of at least one of the two housing parts 121 and 122.

The embodiments shown in Figures 1 to 7 as stated represent exemplary embodiments of improved cooling assemblies 105 and power modules 101 and also detail the steps necessary for their manufacturing.

### Reference Signs

- 1: power module
- 2: first port
- 3: second port
- 4: semiconductor module
- 5: cooling assembly
- 6: clamp
- 7: screw
- 8: baseplate
- 9: (top) surface
- 10: mold body
- 11: substrate
- 12: semiconductor die
- 13: lead
- 14: terminal
- 15: aluminum alloy body part
- 16: coolant
- 17: pin fin
- 18: opening
- 19: O-ring gasket
- 20: groove

- 101: power module
- 102: first port
- 103: second port
- 104: semiconductor module
- 105: cooling assembly
- 106: clamp
- 107: screw
- 108: baseplate
- 109: (top) surface
- 110: mold body
- 111: substrate
- 112: semiconductor die
- 113: lead
- 114: terminal
- 115: plastic body part
- 116: coolant
- 117: pin fin
- 118: opening
- 121: first housing part
- 122: second housing part
- 123: joint
- 128: support structure
- 129: press-fit terminal
- 130: printed circuit board

## Claims

1. A power module (101), comprising:
- at least one semiconductor module (104) having a metal baseplate (108) with an integrated cooling structure;
- a first housing part (121) made from a plastic material and molded around at least parts of the metal baseplate (108) to establish a form-fit connection with the at least one semiconductor module (104); and
- a second housing part (122) made from a plastic material and joined to the first housing part (121) to form a cavity for a coolant (116) for cooling the integrated cooling structure of the at least one semiconductor module (104) .

2. The power module (101) of claim 1, wherein at least one of the first housing part (121) and the second housing part (122) is made from a fiber reinforced polymer material.

3. The power module (101) of claim 1 or 2, wherein the first housing part (121) and the second housing part (122) are joined by at least one of a plastic welding joint, an adhesive bonding joint and a heated material fusion joint.

4. The power module (101) of any one of claims 1 to 3, wherein at least one of the first housing part (121) and the second housing part (122) comprises at least one of polyphenylene sulfide, PPS, polycarbonate, PC, and acrylonitrile butadiene styrene, ABS, reinforced by glass fibers.

5. The power module (101) of any one of claims 1 to 3, wherein at least one of the first housing part (121) and the second housing part (122) is a laminated carbon composite part.

6. The power module (101) of claim 5, wherein at least one of the first housing part (121) and the second housing part (122) comprises pre-impregnated composite fibers.

7. The power module (101) of any one of claims 1 to 6, wherein the at least one semiconductor module (104) comprises at least one power semiconductor die (112) and a plurality of leads (113) connected to the at least one power semiconductor die (112), wherein the plurality of leads (113) are at least partially embedded into the plastic material of the first housing part (121).

8. The power module (101) of any one of claims 1 to 7, further comprising at least one press-fit terminal (129), wherein the first housing part (121) comprises a support structure (128) configured to support the at least one press-fit terminal (129).

9. The power module (101) of any one of claims 1 to 8, wherein the form-fit connection forms a seal for the coolant (116) between the integrated cooling structure of the at least one semiconductor module (104) and the first housing part (121).

10. The power module (101) of claim 9, wherein at least one of
- a surface energy of a part of the metal baseplate (108) embedded into the plastic material of the first housing part (121) is greater than 45 mN/m, and
- a surface roughness of a part of the metal baseplate (108) embedded into the plastic material of the first housing part (121) is between 4 µm to 6 µm.

11. A method for manufacturing a power module (101), comprising:
- placing at least one semiconductor module (104) having a metal baseplate (108) with an integrated cooling structure in a first mold;
- molding a first housing part (121) from a plastic material using the first mold, thereby establishing a form-fit connection between at least parts of the metal baseplate (108) and the plastic material of the first housing part (121) ;
- molding a second housing part (122) from a plastic material; and
- joining the first housing part (121) and the second housing part (122) by a plastic joining method to form a cavity for a coolant (116) for cooling the integrated cooling structure of the at least one semiconductor module (104) .

12. The method of claim 11, wherein the at least one semiconductor module (104) comprises at least one power semiconductor die (112), which is embedded into a mold body (110) before the at least one semiconductor module (104) is placed in the first mold.

13. The method of claim 11, wherein the at least one semiconductor module (104) comprises at least one power semiconductor die (112), which is directly embedded into the plastic material of the first housing part (121) during molding of the first housing part (121).

14. The method of claim 12 or 13, wherein the at least one semiconductor module (104) further comprises a plurality of leads (113) electrically connected to the at least one power semiconductor die (112), the leads (113) being embedded into the plastic material during molding of the first housing part (121) at least partially.

15. The method of any one of claims 11 to 14, wherein the plastic material of at least one of the first housing part (121) and the second housing part (122) are made from pre-impregnated composite fibers and are formed by autoclave processing or out-of-autoclave composite manufacturing processing based on resin-transfer molding or balanced pressure fluid molding.

## Patentansprüche

1. Leistungsmodul (101), umfassend:
- mindestens ein Halbleitermodul (104), das eine Metallbasisplatte (108) mit einer integrierten Kühlstruktur aufweist;
- einen ersten Gehäuseteil (121), der aus einem Kunststoffmaterial besteht und um zumindest Teile der Metallbasisplatte (108) herum geformt ist, um eine formschlüssige Verbindung mit dem mindestens einen Halbleitermodul (104) herzustellen; und
- einen zweiten Gehäuseteil (122), der aus einem Kunststoffmaterial besteht und an den ersten Gehäuseteil (121) gefügt ist, um einen Hohlraum für ein Kühlmittel (116) zum Kühlen der integrierten Kühlstruktur des mindestens einen Halbleitermoduls (104) auszubilden.

2. Leistungsmodul (101) nach Anspruch 1, wobei mindestens einer des ersten Gehäuseteils (121) und des zweiten Gehäuseteils (122) aus einem faserverstärkten Polymermaterial besteht.

3. Leistungsmodul (101) nach Anspruch 1 oder 2, wobei der erste Gehäuseteil (121) und der zweite Gehäuseteil (122) durch mindestens eines einer Kunststoffschweißfügeverbindung, einer Klebefügeverbindung und einer Schmelzfügeverbindung aus erwärmtem Material zusammengefügt sind.

4. Leistungsmodul (101) nach einem der Ansprüche 1 bis 3, wobei mindestens einer des ersten Gehäuseteils (121) und des zweiten Gehäuseteils (122) mindestens eines von Polyphenylensulfid, PPS, Polycarbonat, PC, und Acrylnitril-Butadien-Styrol, ABS, verstärkt durch Glasfasern, umfasst.

5. Leistungsmodul (101) nach einem der Ansprüche 1 bis 3, wobei mindestens einer des ersten Gehäuseteils (121) und des zweiten Gehäuseteils (122) ein laminiertes Kohlenstoffverbundwerkstoffteil ist.

6. Leistungsmodul (101) nach Anspruch 5, wobei mindestens einer des ersten Gehäuseteils (121) und des zweiten Gehäuseteils (122) vorimprägnierte Verbundwerkstofffasern umfasst.

7. Leistungsmodul (101) nach einem der Ansprüche 1 bis 6, wobei das mindestens eine Halbleitermodul (104) mindestens einen Leistungshalbleiter-Die (112) und eine Mehrzahl von Leitungen (113) umfasst, die mit dem mindestens einen Leistungshalbleiter-Die (112) verbunden sind, wobei die Mehrzahl von Leitungen (113) zumindest teilweise in das Kunststoffmaterial des ersten Gehäuseteils (121) eingebettet sind.

8. Leistungsmodul (101) nach einem der Ansprüche 1 bis 7, ferner umfassend mindestens einen Presspassungsanschluss (129), wobei der erste Gehäuseteil (121) eine Stützstruktur (128) umfasst, die dazu ausgelegt ist, den mindestens einen Presspassungsanschluss (129) zu stützen.

9. Leistungsmodul (101) nach einem der Ansprüche 1 bis 8, wobei die formschlüssige Verbindung eine Dichtung für das Kühlmittel (116) zwischen der integrierten Kühlstruktur des mindestens einen Halbleitermoduls (104) und dem ersten Gehäuseteil bildet (121).

10. Leistungsmodul (101) nach Anspruch 9, wobei mindestens eines von Folgendem gilt
- eine Oberflächenenergie eines in das Kunststoffmaterial des ersten Gehäuseteils (121) eingebetteten Teils der Metallbasisplatte (108) ist größer als 45 mN/m, und
- eine Oberflächenrauheit eines in das Kunststoffmaterial des ersten Gehäuseteils (121) eingebetteten Teils der Metallbasisplatte (108) beträgt zwischen 4 µm und 6 µm.

11. Verfahren zum Herstellen eines Leistungsmoduls (101), umfassend:
- Platzieren mindestens eines Halbleitermoduls (104), das eine Metallbasisplatte (108) mit einer integrierten Kühlstruktur aufweist, in einer ersten Form;
- Formen eines ersten Gehäuseteils (121) aus einem Kunststoffmaterial unter Verwendung der ersten Form, wodurch eine formschlüssige Verbindung zwischen zumindest Teilen der Metallbasisplatte (108) und dem Kunststoffmaterial des ersten Gehäuseteils (121) hergestellt wird;
- Formen eines zweiten Gehäuseteils (122) aus einem Kunststoffmaterial; und
- Zusammenfügen des ersten Gehäuseteils (121) und des zweiten Gehäuseteils (122) durch ein Kunststofffügeverbindungsverfahren, um einen Hohlraum für ein Kühlmittel (116) zur Kühlung der integrierten Kühlstruktur des mindestens einen Halbleitermoduls (104) auszubilden.

12. Verfahren nach Anspruch 11, wobei das mindestens eine Halbleitermodul (104) mindestens einen Leistungshalbleiter-Die (112) umfasst, der in einen Formkörper (110) eingebettet wird, bevor das mindestens eine Halbleitermodul (104) in der ersten Form platziert wird.

13. Verfahren nach Anspruch 11, wobei das mindestens eine Halbleitermodul (104) mindestens einen Leistungshalbleiter-Die (112) umfasst, der während des Formens des ersten Gehäuseteils (121) direkt in das Kunststoffmaterial des ersten Gehäuseteils (121) eingebettet wird.

14. Verfahren nach Anspruch 12 oder 13, wobei das mindestens eine Halbleitermodul (104) ferner eine Mehrzahl von Leitungen (113) umfasst, die elektrisch mit dem mindestens einen Leistungshalbleiter-Die (112) verbunden sind, wobei die Leitungen (113) während des Formens des ersten Gehäuseteils (121) zumindest teilweise in das Kunststoffmaterial eingebettet werden.

15. Verfahren nach einem der Ansprüche 11 bis 14, wobei das Kunststoffmaterial mindestens eines des ersten Gehäuseteils (121) und des zweiten Gehäuseteils (122) aus vorimprägnierten Verbundwerkstofffasern bestehen und durch eine Autoklavenbearbeitung oder eine Verbundwerkstoffherstellungsbearbeitung außerhalb eines Autoklaven basierend auf Harzinjektionsformen oder Gleichdruck-Flüssigkeitsformen ausgebildet werden.

## Revendications

1. Module de puissance (101), comprenant :
- au moins un module semi-conducteur (104) ayant une plaque de base métallique (108) avec une structure de refroidissement intégrée ;
- une première partie de boîtier (121) fabriquée à partir d'un matériau plastique et moulée autour au moins de parties de la plaque de base métallique (108) pour établir une connexion à complémentarité de forme avec l'au moins un module semi-conducteur (104) ; et
- une deuxième partie de boîtier (122) fabriquée à partir d'un matériau plastique et assemblée à la première partie de boîtier (121) pour former une cavité pour un fluide frigorigène (116) destiné à refroidir la structure de refroidissement intégrée de l'au moins un module semi-conducteur (104).

2. Module de puissance (101) de la revendication 1, dans lequel la première partie de boîtier (121) et/ou la deuxième partie de boîtier (122) sont fabriquées à partir d'un matériau polymère renforcé de fibres.

3. Module de puissance (101) de la revendication 1 ou 2, dans lequel la première partie de boîtier (121) et la deuxième partie de boîtier (122) sont assemblées par au moins un joint parmi un joint de soudage de plastiques, un joint de liaison adhésive et un joint de fusion de matériau chauffé.

4. Module de puissance (101) de l'une quelconque des revendications 1 à 3, dans lequel la première partie de boîtier (121) et/ou la deuxième partie de boîtier (122) comprennent au moins un composé parmi le sulfure de polyphénylène, PPS, le polycarbonate, PC, et l'acrylonitrile-butadiène-styrène, ABS, renforcé par des fibres de verre.

5. Module de puissance (101) de l'une quelconque des revendications 1 à 3, dans lequel la première partie de boîtier (121) et/ou la deuxième partie de boîtier (122) sont une/des partie(s) en composite de carbone stratifié.

6. Module de puissance (101) de la revendication 5, dans lequel la première partie de boîtier (121) et/ou la deuxième partie de boîtier (122) comprennent des fibres composites préimprégnées.

7. Module de puissance (101) de l'une quelconque des revendications 1 à 6, dans lequel l'au moins un module semi-conducteur (104) comprend au moins une puce semi-conductrice de puissance (112) et une pluralité de fils (113) connectés à l'au moins une puce semi-conductrice de puissance (112), dans lequel la pluralité de fils (113) sont au moins partiellement incorporés à l'intérieur du matériau plastique de la première partie de boîtier (121).

8. Module de puissance (101) de l'une quelconque des revendications 1 à 7, comprenant en outre au moins une borne insérée à force (129), dans lequel la première partie de boîtier (121) comprend une structure de support (128) configurée pour supporter l'au moins une borne insérée à force (129).

9. Module de puissance (101) de l'une quelconque des revendications 1 à 8, dans lequel la connexion à complémentarité de forme forme un joint d'étanchéité pour le fluide frigorigène (116) entre la structure de refroidissement intégrée de l'au moins un module semi-conducteur (104) et la première partie de boîtier (121).

10. Module de puissance (101) de la revendication 9, dans lequel
- une énergie de surface d'une partie de la plaque de base métallique (108) incorporée à l'intérieur du matériau plastique de la première partie de boîtier (121) est supérieure à 45 mN/m, et/ou
- une rugosité de surface d'une partie de la plaque de base métallique (108) incorporée à l'intérieur du matériau plastique de la première partie de boîtier (121) se situe entre 4 µm et 6 µm.

11. Procédé destiné à fabriquer un module de puissance (101), comprenant :
- la mise en place d'au moins un module semi-conducteur (104) ayant une plaque de base métallique (108) avec une structure de refroidissement intégrée dans un premier moule ;
- le moulage d'une première partie de boîtier (121) à partir d'un matériau plastique au moyen du premier moule, ce qui établit ainsi une connexion à complémentarité de forme entre au moins des parties de la plaque de base métallique (108) et le matériau plastique de la première partie de boîtier (121) ;
- le moulage d'une deuxième partie de boîtier (122) à partir d'un matériau plastique ; et
- l'assemblage de la première partie de boîtier (121) et de la deuxième partie de boîtier (122) par un procédé d'assemblage de plastiques pour former une cavité pour un fluide frigorigène (116) destiné à refroidir la structure de refroidissement intégrée de l'au moins un module semi-conducteur (104).

12. Procédé de la revendication 11, dans lequel l'au moins un module semi-conducteur (104) comprend au moins une puce semi-conductrice de puissance (112), qui est incorporée à l'intérieur d'un corps de moule (110) avant que l'au moins un module semi-conducteur (104) soit placé dans le premier moule.

13. Procédé de la revendication 11, dans lequel l'au moins un module semi-conducteur (104) comprend au moins une puce semi-conductrice de puissance (112), qui est directement incorporée à l'intérieur du matériau plastique de la première partie de boîtier (121) pendant le moulage de la première partie de boîtier (121) .

14. Procédé de la revendication 12 ou 13, dans lequel l'au moins un module semi-conducteur (104) comprend en outre une pluralité de fils (113) connectés électriquement à l'au moins une puce semi-conductrice de puissance (112), les fils (113) étant incorporés au moins partiellement à l'intérieur du matériau plastique pendant le moulage de la première partie de boîtier (121) .

15. Procédé de l'une quelconque des revendications 11 à 14, dans lequel le matériau plastique de la première partie de boîtier (121) et/ou la deuxième partie de boîtier (122) est élaboré à partir de fibres composites préimprégnées et est formé par un traitement autoclave ou un traitement de fabrication de composite hors autoclave basé sur un moulage par transfert de résine ou un moulage à fluide sous pression équilibrée.
